**Europäisches Patentamt**

**European Patent Office**

**Office européen des brevets**

(19)

(11) Veröffentlichungsnummer: **0 217 210**
**B1**

(12) # EUROPÄISCHE PATENTSCHRIFT

(45) Veröffentlichungstag der Patentschrift:
04.04.90

(51) Int. Cl.⁴: **H01J 3/02, H01J 37/075**

(21) Anmeldenummer: **86112696.9**

(22) Anmeldetag: **13.09.86**

(54) Elektronenstrahlerzeuger mit einer direkt und einer indirekt beheizbaren Katode.

(30) Priorität: **30.09.85 DE 3534792**

(43) Veröffentlichungstag der Anmeldung:
**08.04.87 Patentblatt 87/15**

(45) Bekanntmachung des Hinweises auf die Patenterteilung:
**04.04.90 Patentblatt 90/14**

(84) Benannte Vertragsstaaten:
**BE CH DE FR GB LI**

(56) Entgegenhaltungen:
**EP-A- 0 012 427**
**DE-A- 2 627 862**
**US-A- 3 273 003**

(73) Patentinhaber: **LEYBOLD AKTIENGESELLSCHAFT,
Wilhelm-Rohn-Strasse 25, D-6450 Hanau am Main 1(DE)**

(72) Erfinder: **Kraft, Reinhard, Mittelstrasse 53,
D-6472 Altenstadt-Höchst(DE)**
Erfinder: **Ranke, Horst, Dr., Brentanostrasse 34,
D-8755 Alzenau(DE)**

(74) Vertreter: **Zapfe, Hans, Dipl.-Ing., Am Eichwald 7,
D-6056 Heusenstamm 2 Rembrücken(DE)**

## Beschreibung

Die Erfindung betrifft einen Elektronenstrahlerzeuger mit einer direkt beheizbaren ersten Katode und einer davor angeordneten, durch von der ersten Katode ausgehende Elektronen beheizbaren zweiten Blockkatode, wobei die Blockkatode über mehrere abstehende Tragstreben mit einem Tragring verbunden ist, der eine koaxiale Zentrierfläche aufweist und die Blockkatode in koaxialer Lage relativ zu einem mit einer zentrischen Bohrung verse-nen scheibenförmigen Teil einer abnehmbaren äußeren Fokussierungselektrode festhält.

Derartige Elektronenstrahlerzeuger werden als Quelle von Elektronenstrahlen hoher Leistung verwendet, wie sie für das Schmelzen und/oder Verdampfen von Werkstoffen im Vakuum benötigt werden. Dabei wird die im wesentlichen aus einer massiven Kreisscheibe bestehende Blockkatode im allgemeinen durch eine aus Draht bestehende, wendelförmig gebogene direkt beheizte Katode aufgeheizt und sendet nun ihrerseits aufgrund einer in dem System vorhandenen Beschleunigungsspannung einen gebündelten Elektronenstrahl aus.

Durch die US-PS 3 273 003 sind verschiedene Formen einer indirekt beheizbaren Blockkatode bekannt, wobei jedoch lediglich angegeben ist, daß die freien Enden der abstehenden Tragstreben mit einer konventionellen Haltevorrichtung verbunden sind. Man ist dabei in der Praxis bisher so verfahren, daß die freien Enden der Tragstreben abgewinkelt und unter Vorspannung in achsparallele Durch-gangslöcher eines scheibenförmigen Teils einge-setzt wurden. Dieser scheibenförmige Teil wurde nun seinerseits wiederum durch Niete mit dem Stirnflansch eines hohlzylindrischen Teils verbunden. Der scheibenförmige und der hohlzylindrische Teil bildeten dabei zusammen die Fokussierungselektrode, häufig auch als Wehnelt-Zylinder bezeichnet.

Bei der bekannten Lösung bestand jedoch folgende Problematik: Das Abwinkeln der Tragstreben war relativ schwierig und nicht immer mit der gewünschten Genauigkeit durchführbar, und auch die kraftschlüssige Halterung in den achsparallelen Durchgangslöchern des scheibenförmigen Teils führte nur nach umständlichen Justierarbeiten zu einer einigermaßen koaxialen Ausrichtung zu einer Mittenbohrung im scheibenförmigen Teil. Diese koaxiale Ausrichtung ist aber wichtig, da durch die geometrische Form der Mittenbohrung die eigentliche Strahlformung bewirkt wird. Durch die weiter oben beschriebene Vernietung entstand eine Unregelmäßigkeit in der Oberfläche der Fokussierungselektrode, die zu unerwünschten Spannungsspitzen mit örtlich überhöhten Feldstärken führte. Gelegentlich ragten auch die unterschiedlich langen abgewinkelten Enden der Tragstreben aus der Stirnseite der Fokussierungselektrode hervor, so daß sich weitere Spannungsspitzen ergaben. Durch die-se Spannungsspitzen wurden Überschläge begün-stigt, die in Vakuumanlagen soweit wie irgend möglich vermieden werden müssen.

Weiterhin sind sowohl die Blockkatode als auch der scheibenförmige Teil der Fokussierungselektrode in Abhängigkeit von der Belastung einem nicht vernachlässigbaren Verschleiß ausgesetzt, und auch im Falle einer Umrüstung des Elektronenstrahlerzeugers müssen die Blockkatode und der scheibenförmige Teil ausgewechselt werden. In beiden Fällen werden die vorstehend beschriebenen Niete durch Aufbohren entfernt. Ein solcher Aufbohrvorgang kann nur wenige Male durchgeführt werden, bis die betreffenden Teile unbrauchbar werden.

Durch die DE-OS 26 27 862 ist ein Elektronenstrahl-Erzeuger der eingangs beschriebenen Gattung bekannt, bei der jedoch der die Blockkatode haltende Tragring am Hauptkörper des Strahlerzeugers befestigt ist, und zwar mittels als Schrauben ausgebildeter elektrischer Durchführungen, die von der Rückseite eines keramischen Isolators her mit dem Tragring verschraubt sind. Der Tragring kann daher nur nach einem vollständigen Zerlegen der bekannten Vorrichtung ausgebaut werden. Die Tragstreben der Blockkatode sind infolgedessen **einzeln** mittels Klemmbacken und Klemmschrauben mit dem Tragring verbunden, so daß bei jedem Auswechseln der Blockkatode um-ständliche und zeitraubende Justierarbeiten erfor-derlich sind, um die Blockkatode genau koaxial zur Fokussierungselektrode auszurichten, die jedoch hierbei nicht zur Verfügung steht, da ansonsten die Zugänglichkeit nicht gegeben wäre. Erst nach vollendeter Montage der Blockkatode wird die scheibenförmige, äußere Fokussierungselektrode mittels einer Überwurfmutter wieder aufgeschraubt.

Der Erfindung liegt daher die Aufgabe zugrunde, einen Elektronenstrahlerzeuger der eingangs beschriebenen Gattung anzugeben, bei dem die Blockkatode relativ zum scheibenförmigen Teil exakt justiert werden kann, bei dem das Auswechseln der Blockkatode und des scheibenförmigen Teils auf einfache Weise möglich ist und bei dem auf der Oberfläche der Fokussierungselektrode keinerlei Oberflächenunregelmäßigkeiten auftreten können.

Die Lösung der gestellten Aufgabe erfolgt erfindungsgemäß dadurch, daß

a) die Blockkatode (3) mit den Tragstreben (22) und dem Tragring (19) eine Baueinheit darstellt, die von der Rückseite her in eine Zentrierfläche (18) im scheibenförmigen Teil (15) der äußeren Fokussierungselektrode (17) eingesetzt ist, und daß

b) der Tragring (19) und der scheibenförmige Teil (15) der äußeren Fokussierungselektrode (17) mittels eines lösbaren Verriegelungsringes (14) gegeneinander verspannt sind.

Beim Erfindungsgegenstand ist - im Gegensatz zum Stand der Technik nach der DE-OS 26 27 862 - eine Baueinheit aus Blockkatode, Tragstreben und Tragring vorhanden, die unmittelbar der äußeren Fokussierungselektrode zugeordnet, und - nach deren Abnahme - leicht auswechselbar ist.

Bei einem solchen Elektronenstrahlerzeuger sind allein durch Lösen des Verriegelungsringes sowohl die Blockkatode als auch der scheibenförmige Teil zum Innern der Fokussierungselektrode hin ausbaubar. Die Blockkatode läßt sich relativ zum Trag-ring durch die Tragstreben außerordentlich genau positionieren, gegebenenfalls unter Verwendung einer Lehre, so daß die aus Blockkatode, Tragstreben und Tragring bestehende Baueinheit beim Einsetzen in den scheibenförmigen Teil äußert exakt justiert wird. Dabei ist auch eine einwandfreie elektrische Verbindung der Tragstreben mit dem Tragring möglich, so daß asymmetrische Stromzuführungen ausgeschaltet sind. Zum Auswechseln brauchen auch keinerlei Nietverbindungen durch Ausbohren gelöst werden, so daß insbesondere der relativ teure scheibenförmige Teil sehr häufig wieder verwendet werden kann. Die Oberfläche der Fokussierungselektrode läßt sich zusätzlich sehr glatt gestalten, so daß Spannungsspitzen mit ihren nachteiligen Wirkungen gleichfalls vermieden werden. Durch den Erfindungsgegenstand entfällt insbesondere die bei der bekannten Lösung äußerst aufwendige Justierung durch unterschiedliches Verbiegen der freien Enden der Tragstreben. Hierbei ist zu berücksichtigen, daß eine solche Justiermöglichkeit nach der ersten Inbetriebnahme nicht mehr gegeben ist, weil das üblicherweise für die Tragstreben verwendete Material beim Aufheizen stark versprödet.

Weitere vorteilhafte Ausgestaltungen des Erfindungsgegenstandes ergeben sich aus den übrigen Unteransprüchen.

Ein Ausführungsbeispiel des Erfindungsgegenstandes und seine wesentlichen Teile werden nachfolgend anhand der Figuren 1 bis 4 näher erläutert.

Es zeigen:

Figur 1 einen Axialschnitt durch einen vollständigen Elektronenstrahlerzeuger,

Figur 2 einen Axialschnitt durch eine aus Blockkatode, Tragstreben und Tragring bestehende Baueinheit in vergrößertem Maßstab,

Figur 3 eine Draufsicht auf den Gegenstand von Figur 1 und

Figur 4 eine Unteransicht des Verriegelungsringes in einem gegenüber Figur 2 und 3 verkleinertem Maßstab.

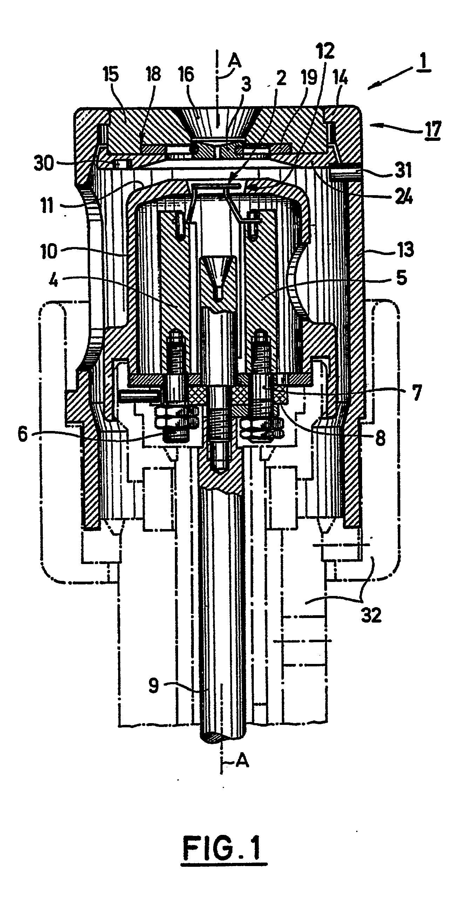

In Figur 1 ist ein Elektronenstrahlerzeuger 1 gezeigt, der eine direkt beheizbare erste Katode 2 und eine durch die erste Katode indirekt beheizbare zweite Katode 3, die sogenannte Blockkatode aufweist. Die erste Katode 2 besteht in ihrem zentralen Teil aus einem spiralförmig gebogenen Teil, der über zwei nach hinten und außen führende Anschlußenden mit metallischen Tragstützen 4 und 5 verbunden sind, über die gleichzeitig die Stromzufuhr bewirkt wird. Die Tragstützen 4 und 5 sind mittels zweier Anschlußbolzen 6 und 7 an einem Isolierkörper 8 gehalten, der seinerseits wieder an einer Tragstange 9 befestigt ist, die gleichzeitig zur Stromzuführung zum rechten Anschlußbolzen 7 führt. Die Stromzuführung zum Anschlußbolzen 6 ist nicht näher gezeigt. Die vorstehend beschriebene Anordnung ist in einer inneren Fokussierungselektrode 10 untergebracht, die in ihrer Stirnseite 11 eine koaxiale Bohrung 12 aufweist, in der die erste Katode 2 konzentrisch angeordnet ist. Dadurch wird ein im Betrieb nach oben (bezogen auf Figur 1) gerichtetes Strahlenbündel erzeugt, das auf die Blockkatode 3 auftrifft und in Abhängigkeit von den Steuerung der Potentialdifferenz eine mehr oder weniger starke Aufheizung der Blockkatode 3 bewirkt, so daß diese nun ihrerseits ein wiederum nach oben gerichtetes Strahlenbündel aussendet.

Die innere Fokussierungselektrode 10 ist konzentrisch von einem Hohlzylinder 13 umgeben, der einen Stirnflansch 14 aufweist. In die dadurch gebildete kreisförmige Öffnung ist ein scheibenförmiger Teil 15 so eingesetzt, daß seine zentrische Bohrung 16 konzentrisch zur gemeinsamen Achse A-A des gesamten Systems verläuft. Der scheibenförmige Teil 15 stützt sich über eine nicht näher bezeichnete Schulterfläche am Stirnflansch 14 ab. Der Hohlzylinder 13 und der scheibenförmige Teil 15 bilden zusammen eine äußere Fokussierungselektrode 17.

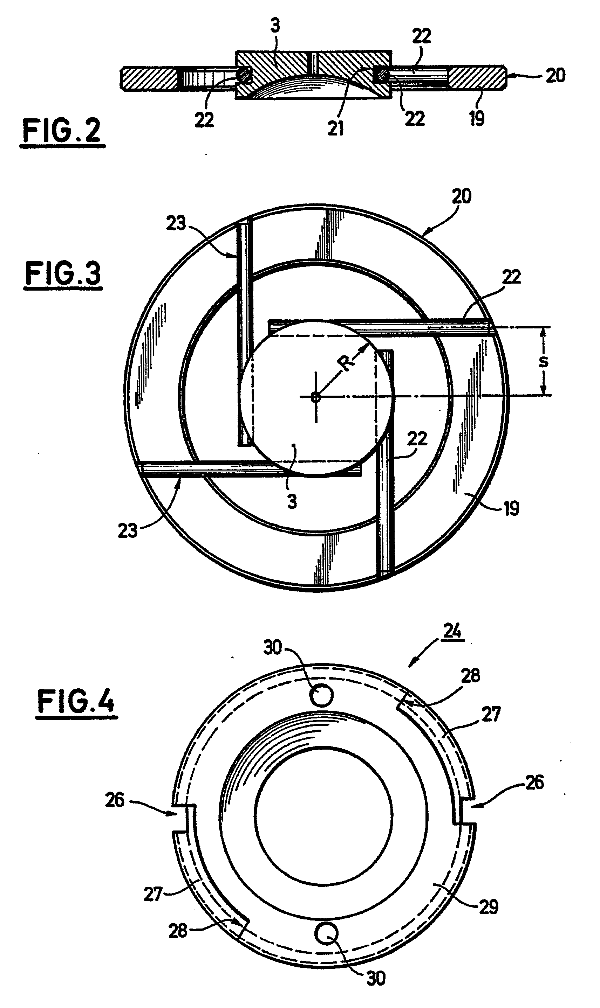

Im scheibenförmigen Teil 15 befindet sich eine zur Bohrung 16 konzentrische erste Zentrierfläche 18, die als schmale Zylinderfläche ausgebildet ist. Die vopn der Zentrierfläche 18 begrenzte zylindrische Ausnehmung dient zur Aufnahme der Baugruppe nach den Figuren 2 und 3, zu der ein Tragring 19 gehört. Dieser Tragring besitzt eine zur ersten Zentrierfläche 18 komplementäre zweite Zentrierfläche 20, welche gleichfalls eine schmale Zylinderfläche ist. Im Innern des Tragrings 19 befindet sich die Blockkatode 3, in der eine Umfangsnut 21 angeordnet ist, in die in etwa tangentialer Ausrichtung und äquidistant auf dem Umfang verteilt vier Tragstreben 22 angeordnet sind. Die Tragstreben 22 sind als Zylinderbolzen ausgeführt und mit ihren inneren Enden in die Umfangsnut 21 eingepreßt. Mit ihrem jeweils anderen Ende ist jede der Tragstreben 24 in eine entsprechende Nut 23 im Tragring 19 eingepreßt, wobei jede dieser Nuten entlang einer Sehne verläuft, die um das Maß "s" parallel zur einer diametralen Linie versetzt ist. Wie insbesondere aus Figur 3 ersichtlich ist, entspricht das Maß "s" dem Radius "R" der Blockkatode 3 abzüglich dem halben Durchmesser der Tragstreben 22. Es versteht sich, daß zwischen der Blockkatode 3 und dem Innendurchmesser des Tragrings 19 ein ausreichend großer Abstand vorhanden ist.

Wie wiederum aus Figur 1 ersichtlich ist, wird der Tragring 19 im scheibenförmigen Teil 15 durch einen Verriegelungsring 24 gehalten, dessen Einzelheiten anhand von Figur 4 erläutert werden. Der Innendurchmesser des Verriegelungsrings 24 entspricht dabei im wesentlichen dem Innendurchmesser des Tragrings 19. Auf seinem äußeren Umfang 25 besitzt der Verriegelungsring 24 zwei radiale Nuten 26, die sich über die gesamte Dicke des Verriegelungsrings erstrecken. Von diesen Nuten 26 gehen zwei in Umfangsrichtung verlaufende schiefe Ebenen 27 aus, deren Endkanten 28 in der unteren Begrenzungsfläche 29 des Verriegelungsrings 24 liegen. Weiterhin sind zwei Bohrungen 30 vorhanden, die zum Ansetzen eines Werkzeugs zum Zwecke des Verdrehens des Verriegelungsringes 24 dienen.

Zur Festlegung des Verriegelungsringes, dessen Außendurchmesser etwa dem Innendurchmesser des Hohlzylinders 13 entspricht, sind in diesem Hohlzylinder an diametral gegenüberliegenden Stellen (entsprechend der Lage der Nuten 26) zwei Zylinderzapfen 31 angeordnet, von denen nur einer gezeigt ist. Aufgrund der Nuten 26 läßt sich der Verriegelungsring 24 zwischen die Zylinderzapfen 31 und das scheibenförmige Teil 15 bringen. Durch Verdrehen des Verriegelungsringes 24 im Uhrzeigersinn (bezogen auf Figur 4) gleiten die schiefen Ebenen 27 über die Zylinderzapfen 31 in Richtung auf die Endkanten 28, so daß der Verriegelungsring 24 gegen die Zylinderzapfen 31 einerseits und gegen den scheibenförmigen Teil 15 andererseits verspannt wird. Dabei wird der Teil 15 seinerseits gegen den Stirnflansch 14 gepreßt.

Es ergibt sich aus Figur 1, daß durch die erfindungsgemäße Ausbildung eine außerordentlich exakte geometrische Ausrichtung bzw. Justierung sämtlicher Teile zueinander ermöglicht wird. Außerdem ist eine außerordentlich einfache Auswechselbarkeit der betreffenden Teile gewährleistet.

Gemäß Figur 1 sind die den Strahlerzeuger 1 bildenden Teile in einer Halterung 32 befestigt, die jedoch nur strichpunktiert angedeutet ist, weil sie nicht mehr Teil der Erfindung ist.

**Patentansprüche**

1. Elektronenstrahlerzeuger (1) mit einer direkt beheizbaren ersten Katode (2) und einer davor angeordneten, durch von der ersten Katode (2) ausgehende Elektronen beheizbaren zweiten Blockkatode (3), wobei die Blockkatode (3) über mehrere abstehende Tragstreben (22) mit einem Tragring (19) verbunden ist, der eine koaxiale Zentrierfläche (20) aufweist und die Blockkatode (3) in koaxialer Lage relativ zu einem mit einer zentrischen Bohrung (16) versehenen scheibenförmigen Teil (15) einer abnehmbaren äußeren Fokussierungselektrode (17) festhält, dadurch gekennzeichnet, daß
a) die Blockkatode (3) mit den Tragstreben (22) und dem Tragring (19) eine Baueinheit darstellt, die von der Rückseite her in eine Zentrierfläche (18) im scheibenförmigen Teil (15) der äußeren Fokussierungselektrode (17) eingesetzt ist, und daß
b) der Tragring (19) und das scheibenförmige Teil (15) der äußeren Fokussierungselektrode (17) mittels eines lösbaren Verriegelungsringes (24) gegeneinander verspannt sind.

2. Elektronenstrahlerzeuger nach Anspruch 1, dadurch gekennzeichnet, daß die Tragstreben (22) als Zylinderbolzen ausgeführt und mit ihrem einen Ende in mindestens eine Umfangsnut (21) der Blockkatode (3) und mit ihrem anderen Ende in eine entlang einer Sehne des Tragrings (19) verlaufenden Nut (23) desselben formschlüssig und unverlierbar eingesetzt sind.

3. Elektronenstrahlerzeuger nach Anspruch 1, dadurch gekennzeichnet, daß der Verriegelungsring (24) auf seinem äußeren Umfang (25) mindestens zwei radiale Nuten (26) und von diesen Nuten ausgehend in Umfangsrichtung verlaufende schiefe Ebenen (27) aufweist.

**Claims**

1. Electron gun (1) with a directly heatable first cathode (2) and a second block cathode (3) which is disposed in front of the first cathode and is heatable by means of electrons originating from the first cathode (2), the block cathode (3) being connected by a plurality of projecting support struts (22) to a supporting ring (19), which has a coaxial centering surface (20) and holds the block cathode (3) in a coaxial position relative to a disk-shaped part (15), having a central bore (16), of a removable external focussing electrode (17), characterised in that
a) the block cathode (3) with the support struts (22) and the supporting ring (19) form a structural unit which is inserted from the rear into a centering surface (18) in the disk-shaped part (15) of the external focussing electrode (17), and
b) the supporting ring (19) and the disk-shaped part (15) of the external focussing electrode (17) are braced against one another by means of a detachable locking ring (24).

2. Electron gun according to claim 1, characterised in that the support struts (22) take the form of cylinder bolts, which are positively and captively inserted at one end in at least one peripheral groove (21) of the block cathode (3) and at the other end in a groove (23) of the supporting ring (19) extending along a chord of said ring.

3. Electron gun according to claim 1, characterised in that the locking ring (24) has on its outer periphery (25) at least two radial grooves (26) and inclined planes (27) originating from these grooves and extending in a peripheral direction.

**Revendications**

1. Générateur de faisceau électronique (1), comportant une première cathode à chauffage direct (2) et, agencée en avant, une deuxième cathode-bloc (3) chauffée par des électrons partant de la première cathode (2), la cathode-bloc (3) étant, par l'intermédiaire de plusieurs membres-supports en saillie (22), assemblée à un anneau-support (19) qui présente une surface de centrage coaxiale (20) et maintient la cathode-bloc (3) en situation coaxiale par rapport à une pièce discoïdale (15) qui est munie d'un trou central (16) et qui appartient à une électrode extérieure de focalisation (17), laquelle est amovible, caractérisé par le fait que
a) la cathode-bloc (3) constitue, avec les membres-supports (22) et avec l'anneau-support (19), un module qui est inséré, par le côté arrière dans une surface de centrage (18) dans la pièce discoïdale (15) de l'électrode de focalisation extérieure (17), et par le fait que
b) l'anneau-support (19) et la pièce discoïdale (15) de l'électrode de focalisation extérieure (17) sont serrés l'un contre l'autre au moyen d'un anneau de verrouillage amovible (24).

2. Générateur de faisceau électronique selon revendication 1, caractérisé par le fait que les membres-supports (22) sont réalisés en tant que tiges cylindriques et sont insérés de manière imperdable, avec formation d'une liaison mécanique positive, par la cathode-bloc (3) et, par leur autre extrémité, dans une rainure (23) s'étendant le long d'une corde de l'anneau-support (19).

3. Générateur de faisceau électronique selon revendication 1, caractérisé par le fait que l'anneau de verrouillage (24) présente, sur sa périphérie extérieure (25), au moins deux rainures radiales (26) et, partant de ces rainures, des plans obliques (27) s'étendant en direction circonférentielle.

EP 0 217 210 B1

**FIG.1**

**FIG.2**

**FIG.3**

**FIG.4**